# EUROPEAN PATENT SPECIFICATION

(11) **EP 2 461 353 B1**
(45) Date of publication and mention of the grant of the patent: **09.09.2015**
(21) Application number: 10804606.1
(22) Date of filing: 30.04.2010
(51) Int. Cl.: H01L 21/304, B24B 37/26, B24D 18/00

(54) **CMP POLISHING PAD AND METHOD FOR MANUFACTURING SAME**
CMP-POLIERKISSEN UND VERFAHREN ZU SEINER HERSTELLUNG
TAMPON DE POLISSAGE CMP ET PROCÉDÉ DE FABRICATION CORRESPONDANT

(30) Priority: 30.07.2009 KR 20090069960
(43) Date of publication of application: 06.06.2012
(73) Proprietor: Industry-University Cooperation Foundation Sogang University, Seoul 121-742 (KR)
(72) Inventor: KIM, Chil Min, Seoul 158-055 (KR)
(74) Representative: Gassner, Wolfgang
(86) International application number: PCT/KR2010/002728
(87) International publication number: WO 2011/013893

(56) References cited:
- KR-A- 20000 070 068
- KR-A- 20030 012 655
- KR-B1- 100 191 227
- US-A1- 2002 124 958
- US-A1- 2007 235 904

## Description

### [Technical Field]

The present disclosure relates to a method for manufacturing a Chemical Mechanical Polishing (CMP) the same, and more particularly, to a method for manufacturing a CMP polishing pad having holes formed by laser beams on the surface thereof in order to improve the stability of a CMP process.

### [Background Art]

Semiconductors are devices obtained by high-density integration of electronic devices such as transistors or capacitors on a semiconductor substrate such as silicon, and are fabricated by using deposition, photolithography and etching technologies. Repetition of such deposition, photolithography and etching processes results in formation of a pattern having a specific shape. When the formation of patterns is repeated in a layered structure, a level difference gradually becomes severe at the top of the resultant structure. Such a severe level difference at the top of the structure makes the focus of a photomask pattern unclear in the subsequent photolithography process, thereby making it difficult to form a fine pattern.

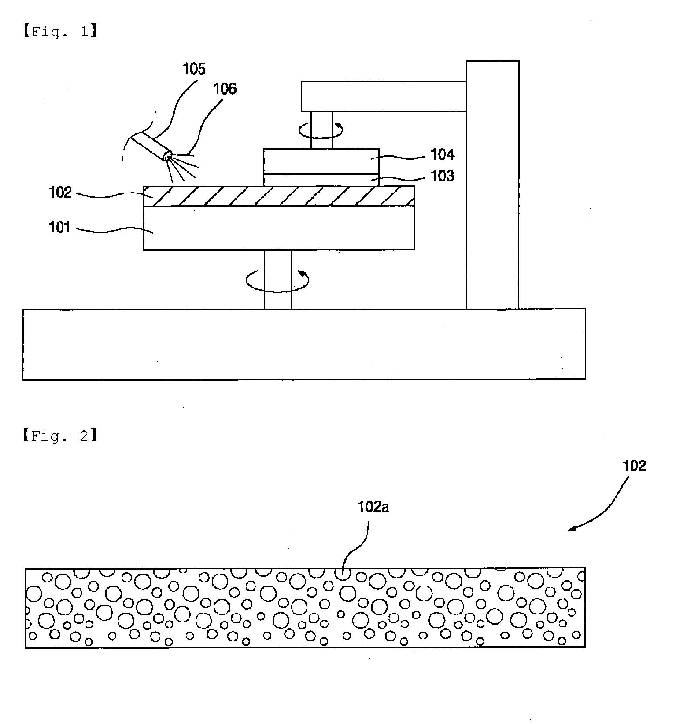

One of the technologies including reducing the level difference on a substrate to increase resolution in photolithography is Chemical Mechanical Polishing (CMP). CMP includes polishing a substrate having a level difference mechanically and chemically to planarize the top of the substrate. Fig. 1 is a schematic view illustrating a CMP process. Referring to Fig. 1, the CMP process is carried out by allowing a wafer 103 to rotate while being in contact with a rotating CMP polishing pad 102 so that the layer formed on the top of a wafer 103 may be polished. The CMP polishing pad 102 is bound to a rotating flat table 101 and the wafer 103 is rotated while being in contact with the CMP polishing pad 102 by way of a carrier 104. Herein, slurry 106 is supplied from a slurry feed nozzle 105 to the top of the CMP polishing pad 102.

CMP polishing pads are consumable goods for use in polishing wafer surfaces and are essential for CMP processes. The slurry is present between the CMP polishing pad and the wafer surface during CMP to carry out chemical mechanical polishing of the wafer surface. Then, the used slurry is discharged to the exterior. To retain the slurry on the CMP polishing pad for a predetermined time, it is required for the CMP polishing pad to store the slurry thereon. Such slurry storability of the CMP polishing pad may be obtained by pores or holes formed on the polishing pad. In other words, the slurry is introduced into the pores or holes formed on the CMP polishing pad so that the semiconductor surface may be polished efficiently for a long time. In order to ensure that the CMP polishing pad inhibits leakage of the slurry and provides high polishing efficiency, it is required that the shapes of the pores or holes are controlled well and the physical properties, such as hardness, of the polishing pad are maintained in an optimized condition.

Conventional CMP polishing pads have been obtained by forming pores with an irregular size and arrangement inside polishing pads by a physical or chemical method. Fig. 2 is a sectional view showing a CMP polishing pad obtained according to the related art. Referring to Fig. 2, pores 102a having various shapes and sizes are arranged in a randomly distributed form on the surface or inside of a polishing pad 102 made of polymer.

One of the physical methods among the conventional methods for forming pores or holes on a CMP polishing pad is mixing a micro-sized material with a material for forming a polishing pad. In this case, it is required that a porous micro-sized material is placed in such a manner that it may be mixed well with a polishing pad material at the initial time of polishing pad fabrication. However, it is difficult to allow the micro-sized material to be mixed well with the polishing pad material by a physical method. Moreover, the micro-sized material is not uniform in size. In general, the average pore diameter of pores formed by a physical method is about 100 micrometers, but each pore has a diameter ranging from several tens micrometers to several hundred micrometers. This results from a technical limitation in forming the pores. In addition, when fabricating a polishing pad, pores are randomly distributed at different positions due to the gravity. Thus, it is difficult to obtain a polishing pad having uniform quality. When the pores formed on the CMP polishing pad are not uniform in size or distribution, the polishing efficiency varies with position or time while a wafer is polished with a high precision.

One of the chemical methods for forming pores on a CMP polishing pad uses water or liquid capable of being converted into gas. When water or such liquid is introduced to polyurethane solution and then heated, pores are formed while the liquid is converted into gas. However, such a method for forming pores by using gas is still problematic in that maintenance of a uniform pore size is difficult. Therefore, there has been a need for developing a method for maintaining a uniform shape of the pores or holes formed on a CMP polishing pad and controlling the distribution of pores or holes as desired.

US 2002/0124958 A1 discloses a method for manufacturing a CMP polishing pad composed of a photosensitive material, wherein the method comprises a step of irradiating the CMP polishing pad with laser beams. Upon exposing the photosensitive material to radiation, in particular laser radiation, the photosensitive material becomes more soluble in a selected etchant. Holes are formed in the polishing pad by contacting the irradiated photosensitive material with an etching agent.

### [Disclosure]

### [Technical Problem]

The present disclosure is directed to providing a method for manufacturing a CMP polishing pad having holes formed on the surface thereof, wherein the holes have a diameter controlled to a predetermined size.

### [Technical Solution]

The present disclosure provides a method for manufacturing a CMP polishing pad, including: determining a diameter of holes to be formed on a CMP polishing pad; determining a particular type of laser to be used according to the diameter of holes; determining a particular type of light-absorbing material according to the type of laser; dispersing the light-absorbing material in or on the surface of the CMP polishing pad; and irradiating the CMP polishing pad having the light-absorbing material dispersed with the laser beams to form holes.

According to an embodiment, the diameter of holes may be in proportion to the wavelength of laser beams.

According to still another embodiment, the laser beams may have a median wavelength of 300-20,000 nm.

According to still another embodiment, the holes may have a diameter of 1-200 µm.

According to still another embodiment, the light-absorbing material may absorb light in a wavelength range of 300-15,000 nm.

According to still another embodiment, the light-absorbing material may be at least one material selected from the group comprising cyanine dyes, dithiolene dyes, diimmonium dyes, quinone dyes, rhodamine dyes, victoria dyes, methylene dyes, brilliant dyes, naphthalene dyes, repid-filter gelb, echtblau, pinaorthol dyes, pyrylium dyes, thionin dyes, nile blue dyes, cresyl dyes, oxazine dyes, resorufin dyes, resazurin dyes, pyronin dyes, acridine dyes and kiton dyes.

According to still another embodiment, a plurality of holes is to be formed on the CMP polishing pad, and the distribution and depth of the holes may be controlled by varying the position of the CMP polishing pad.

According to yet another embodiment, a plurality of holes is to be formed on the CMP polishing pad, and the distribution and depth of the holes may be controlled by varying the position of the laser.

Furthermore, the step of dispersing the light-absorbing material in or on the surface of the CMP polishing pad can be performed by attaching a film having a light-absorbing material dispersed therein to the surface of the CMP polishing pad.

Moreover, a plurality of holes can be generated in the CMP polishing pad by forming a light-absorbing material layer on the surface of the CMP polishing pad and irradiating the light-absorbing material layer with laser beams so that the laser beams penetrate through the light-absorbing material layer and the holes are formed to a predetermined depth of the CMP polishing pad.

### [Advantageous Effects]

The CMP polishing pad disclosed herein uses a light-absorbing material capable of absorbing light in a specific range of wavelengths on the surface thereof or therein, and thus allows formation of holes using laser beams. Therefore, it is possible to form holes having a desired diameter effectively on the CMP polishing pad by selecting the wavelength of laser beams and the light-absorbing material corresponding thereto according to the diameter of holes to be formed. In addition, since the holes are formed by laser beams, they may have a desired depth and distribution in the polishing pad. Further, it is possible to carry out a CMP process with high polishing efficiency and high process stability, depending on the type of a material to be polished or the composition of slurry.

### [Description of Drawings]

The above and other objects, features and advantages of the present disclosure will become apparent from the following description of certain exemplary embodiments given in conjunction with the accompanying drawings, in which:
Fig. 1 is a schematic view showing a CMP process;
Fig. 2 is a sectional view of a CMP polishing pad obtained according to the related art;
Fig. 3 is a schematic view showing a method for forming holes with a desired distribution and depth on a CMP polishing pad by using a laser;
Fig. 4 is a sectional view showing a CMP polishing pad having holes formed to a predetermined depth by using laser beams;
Fig. 5 is a flow chart showing how to select a light-absorbing material to be dispersed on a CMP polishing pad according to the present disclosure;
Fig. 6 is a sectional view showing a CMP polishing pad having a light-absorbing material dispersed therein according to an embodiment;
Fig. 7 is a sectional view showing a CMP polishing pad having a light-absorbing material dispersed therein according to another embodiment; and
Fig. 8 is a sectional view showing the holes formed on a CMP polishing pad having a light-absorbing material according to the present disclosure.

### [Best Mode]

Hereinafter, the embodiments of the present disclosure will be described in detail with reference to accompanying drawings.

The CMP polishing pad disclosed herein has a plurality of holes formed on at least one surface thereof, wherein the holes are formed by dispersing a light-absorbing material in or on the surface of a CMP polishing pad and irradiating the light-absorbing material with laser beams. The holes are formed by laser beams, and have a diameter determined by the wavelength of the laser beams.

It is possible to maintain a uniform diameter of holes by forming the holes on the CMP polishing pad by using laser beams. The holes formed with a uniform diameter on the CMP polishing pad allow the CMP polishing pad to retain slurry for a predetermined time, thereby ensuring high CMP efficiency and process stability. Such formation of holes using laser beams is accomplished by irradiating the polishing pad with strong laser beams having a range of wavelengths capable of being absorbed by the CMP polishing pad so that the materials forming the polishing pad may be molten partially.

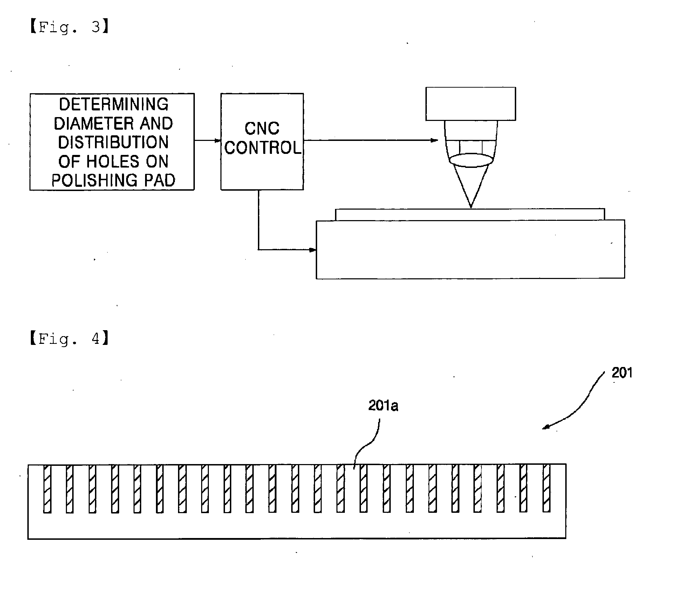

The distribution and depth of the holes formed on the CMP polishing pad may be controlled by adjusting the position of the polishing pad or that of the laser. Fig. 3 is a schematic view showing a method for forming holes with a desired distribution and depth on a CMP polishing pad by using a laser. Referring to Fig. 3, the distribution and depth of the holes to be formed on the polishing pad are determined first, and then they are programmed so that a laser unit or a mobile mechanism attached to the CMP polishing pad may be controlled by a computer numerical control (CNC) process. In this manner, it is possible to control the distribution and depth of the holes. The distribution of the holes formed on the CMP polishing pad is controlled by moving the laser unit or mobile mechanism in the horizontal direction, while the depth of the holes is controlled by the intensity or exposure time of the laser beams or by moving the laser unit or mobile mechanism in the vertical direction.

Fig. 4 is a sectional view showing a CMP polishing pad having holes formed to a predetermined depth by using laser beams. Referring to Fig. 4, holes having a uniform diameter are formed on the top surface of the CMP polishing pad to a uniform depth. Although the holes shown in Fig. 4 have the same depth and same interval, it is also possible to form holes having various distribution patterns and different depths on the CMP polishing pad by controlling the horizontal and vertical movement of the laser unit or mobile mechanism.

When forming the holes on the CMP polishing pad by using laser beams, there is a certain limitation in laser beam absorbance of the CMP polishing pad depending on the wavelength range of laser beams and materials for forming the CMP polishing pad. In general, CMP polishing pads are made of polyurethane polymers, which have high absorbance to far IR rays and UV rays. When forming holes on a CMP polishing pad made of a polyurethane polymer, use of carbon dioxide laser beams having a wavelength of 10.64 µm makes it difficult to control the diameter of holes to 100 µm or less due to the wavelength of the carbon dioxide laser beams. If the holes formed on the CMP polishing pad have a diameter larger than 100 µm, the CMP process using the pad provides poor polishing efficiency. When UV laser beams having a smaller wavelength range than carbon dioxide laser beams are used instead of carbon dioxide laser beams, it is possible to control the diameter of the holes formed on the CMP polishing pad to an extent of several micrometers. However, in this case, it is still difficult to control the diameter to an extent of several tens micrometers. If the holes formed on the CMP polishing pad have a diameter as small as several micrometers, an excessively large number of holes are to be formed per unit area of the pad, resulting in an increase in processing time and degradation of production efficiency. In brief, when forming holes on a CMP polishing pad by using laser beams, the range of controllable hole diameters is in proportion to the wavelength range of laser beams. Therefore, laser units of near IR rays or visible rays may be used to form holes having a diameter of several tens micrometers on a CMP polishing pad. In this case, it is required for the materials forming the CMP polishing pad to absorb the light having the corresponding range of wavelengths.

To solve the above-mentioned problem, according to the present disclosure, a light-absorbing material is dispersed in a CMP polishing pad. When dispersing an adequate light-absorbing material is dispersed in a CMP polishing pad according to the wavelength range of laser beams used for forming holes, it is possible to freely control the diameter of holes within a range of several micrometers to several hundred micrometers. In other words, a light-absorbing material selected according to the wavelength of laser beams is dispersed on the surface of or inside a CMP polishing pad so that the light absorbance to a range of near IR rays to visible rays may be increased. In this manner, it is possible to form holes on a polishing pad more efficiently.

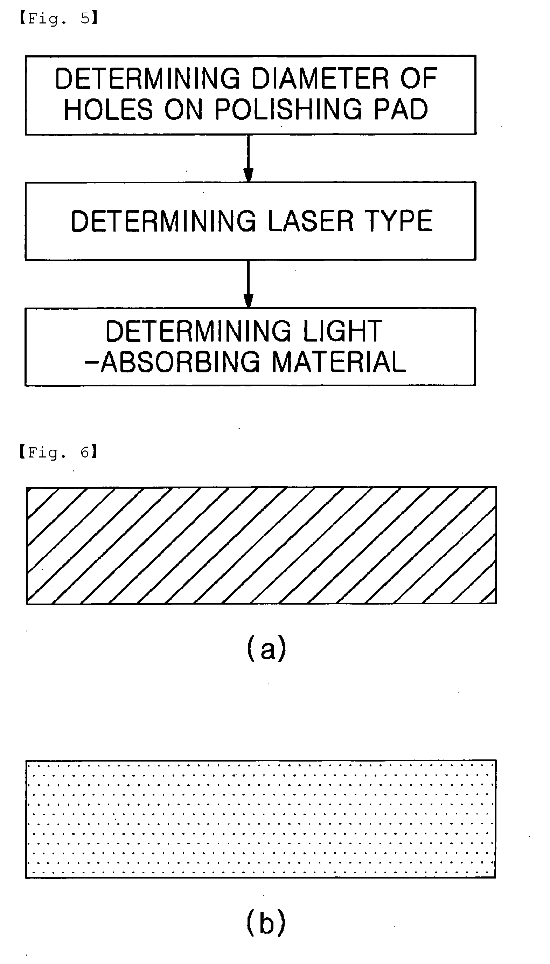

Fig. 5 is a flow chart showing how to select a light-absorbing material to be dispersed on a CMP polishing pad according to the present disclosure. Referring to Fig. 5, a diameter of holes to be formed on a polishing pad is determined first according to the particular type of a CMP process and that of a material to be polished. Next, an adequate wavelength range of laser beams and a particular type of laser unit are determined according to the diameter of holes determined as mentioned above. Finally, determined is a light-absorbing material capable of absorbing the light corresponding to the thus determined wavelength range of laser beams. Polyurethane polymers used for forming CMP polishing pads have high absorbance to far IR rays and UV rays but their absorbance to the light corresponding to near IR rays and visible rays is not significantly high. Therefore, it is required to disperse a light-absorbing material capable of absorbing the light corresponding to near IR rays and visible rays on the surface of or in a polishing pad. Laser units generating light of a range of visible rays or near IR rays include GaAs lasers (0.83 µm), Nd-YAG lasers (1.06 µm) or HF lasers (2.8 µm). In addition to those lasers, various types of lasers capable of generating light of an adequate wavelength range may be used. The light-absorbing material may be selected according to the wavelength range of the light generated from a specific laser unit. Conventional dyes or organic or inorganic materials known to absorb the light of a specific wavelength range may be used. Particular examples of the light-absorbing material absorbing light of near IR wavelengths include cyanine dyes, dithiolene dyes, diimmonium dyes, quinone dyes, rhodamine dyes, victoria dyes, methylene dyes, brilliant dyes, naphthalene dyes, repid-filter gelb, echtblau, pinaorthol dyes, pyrylium dyes, thionin dyes, nile blue dyes, cresyl dyes, oxazine dyes, resorufin dyes, resazurin dyes, pyronin dyes, acridine dyes and kiton dyes. Particular examples of the cyanine dyes include phthalocyanine compounds, naphthalocyanine compounds, amino group-containing phthalocyanine compounds, fluorinecontaining phthalocyanine compounds, etc. Particular examples of the dithiolene dyes include bis(dithiobenzyl) nickel complex compounds, bis(1,2-acenaphthylenedithilolite) nickel complex compounds, 4-tert-butyl-1,2-benzenedithiol nickel complex compounds, alkoxy group-containing bis(dithiobenzyl) nickel complex compounds, etc. Although some kinds of dyes are exemplified, various kinds of dyes other than the abovelisted dyes may be used. Diimmonium dyes absorbing light within a wavelength range of 0.95-1.1 µm may also be used as a light-absorbing material according to the present disclosure. Light-absorbing materials absorbing light of a wavelength ranges corresponding to visible rays include rhodamine dyes absorbing green light with a wavelength range of 0.532 µm or the like.

Fig. 6 is a sectional view showing a CMP polishing pad having a light-absorbing material dispersed therein according to an embodiment. Referring to Fig. 6, the light-absorbing material may be incorporated to and dispersed in a polishing pad as shown in portion (a). Otherwise, the light-absorbing material may be dispersed uniformly inside the polishing pad in the form of particles as shown in portion (b). In order to allow the light-absorbing material to be incorporated to the materials forming the polishing pad as shown in portion (a), the light-absorbing material having high miscibility with a polyurethane polymer may be selected. In addition, when the light-absorbing material is dispersed in a polyurethane polymer in the form of particles as shown in portion (b), it is required for the light-absorbing material to be dispersed uniformly in order to maintain a uniform diameter of holes along the depth of the pad. Such a light-absorbing material in the form of particles is molten by itself in the presence of laser beams. Otherwise, even when the light-absorbing material is not molten, it transfers heat to the surroundings so that the polyurethane polymer may be molten. The particle may have a size controlled to 1/10 or less of the diameter of laser beams.

According to another embodiment, the light-absorbing material may be dispersed on the surface of the CMP polishing pad. When the light-absorbing material is dispersed in the polishing pad, it is miscible with the polyurethane polymer forming the polishing pad or it is dispersed uniformly in the polyurethane polymer in the form of particles. On the contrary, when the light-absorbing material is dispersed on the surface of the polishing pad, the particle-like light-absorbing material is distributed and dispersed predominantly on the surface of the polishing pad, or is applied to the surface of the polishing pad. When the particle-like light-absorbing material is distributed predominantly on the surface of the polishing pad, it is assumed that a higher proportion of the particle-like light-absorbing material is distributed on the bottom surface of the polishing pad due to the gravity during the fabrication of the polishing pad. This may be applied advantageously to formation of holes having a relatively small depth on the polishing pad. The other embodiment in which the light-absorbing material is applied to the surface of the polishing pad may be applied advantageously to dispersion of a light-absorbing material having low miscibility with the materials forming the polishing pad on the polishing pad.

According to still another embodiment, the light-absorbing material may be formed as a separate layer on the surface of the CMP polishing pad. Methods for forming a light-absorbing material as a separate layer on the CMP polishing pad include methods for spreading a light-absorbing material onto the polishing pad, and methods for coating a film containing a light-absorbing material on the polishing pad. The former may include spreading a light-absorbing material onto the surface of the polishing pad through a spin coating process, etc., spreading a solid-phase light-absorbing material onto the surface of the polishing pad through a vapor phase deposition process, or adding a particle-like light-absorbing material to a solution containing a polymer resin and a solvent and spreading the solution onto the surface of the polishing pad. The latter may include dispersing a light-absorbing material in a film and coating the film on the surface of the polishing pad, or spreading a light-absorbing material onto the surface of a film and coating the film on the surface of the polishing pad. Herein, the film may be formed of a polymer resin and may be coated on the polishing pad by using an adhesive or hot press. When the light-absorbing material is formed as a separate layer on the surface of the polishing pad, laser beams irradiated to the polishing pad are absorbed first by the light-absorbing material formed on the polishing pad and then penetrate through the pad, so that holes are formed to a predetermined depth. Thus, such a light-absorbing material formed as a separate layer on the surface of the CMP polishing pad increases light absorbance while not changing the intrinsic physical properties of the CMP polishing pad.

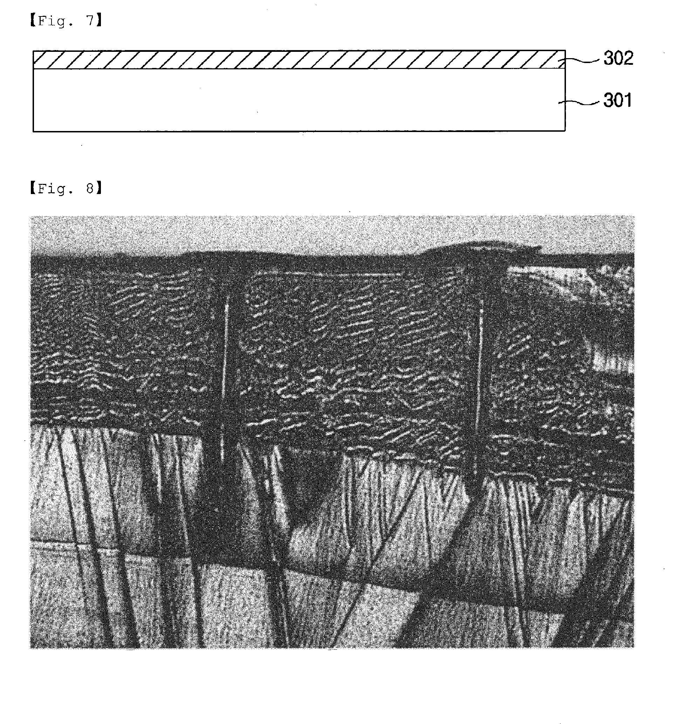

Fig. 7 is a sectional view showing a CMP polishing pad having a light-absorbing material formed as a separate layer on the surface of the CMP polishing pad according to another embodiment. Referring to Fig. 7, a light-absorbing material layer 302 is formed as a separate layer on the CMP polishing pad 301. In Fig. 7, the thickness of the light-absorbing material layer is exaggerated so that the light-absorbing material layer is differentiated clearly from the polishing pad. When the light-absorbing material layer 302 is formed as a film, an adhesive layer (not shown) may be inserted between the light-absorbing material layer 302 and the polishing pad 301.

Fig. 8 is a sectional view showing the holes formed on a CMP polishing pad having a light-absorbing material according to the present disclosure. Referring to Fig. 8, holes having a diameter of 70 µm are formed on the CMP polishing pad to a depth of 2,000 µm. Therefore, it can be seen that holes having such a controlled diameter, which, otherwise, cannot be obtained easily according to the related art, are formed effectively on the CMP polishing pad by dispersing a light-absorbing material in the polishing pad.

The diameter of the holes formed on the CMP polishing pad may be controlled within a wide range according to the particular type of CMP process and that of the material to be polished. The diameter of the holes formed on the CMP polishing pad may be 1-200 µm. When the hole diameter is smaller than 1 µm, an excessively large number of holes are formed per unit area of a polishing pad, resulting in degradation of production efficiency of polishing pads. When the hole diameter is larger than 200 µm, it is difficult to retain slurry in the polishing pad. The laser beams used for forming the holes may have a wavelength ranging from 300 nm to 20,000 nm. In addition, the light-absorbing material dispersed in the polishing pad may absorb the light within a wavelength range of 300 nm to 15,000 nm. The wavelength range of laser beams is determined considering the diameter of the holes formed on the CMP polishing pad. The absorption wavelength range of the light-absorbing material is determined in such a manner that it compensate for a deficiency in the light absorption wavelength range of a polyurethane polymer.

When forming holes in a CMP polishing pad by using laser beams, the holes may be distributed in various manners. The holes may be arranged in a regular, random, chaos or fractal pattern, or a combination thereof. The arrangement of holes may be selected considering the material to be polished, particular type of slurry or wafer size, etc. For example, the distribution of the holes formed on the CMP polishing pad may be realized in such a manner that a higher proportion of holes is present at the center and the number of holes gradually decreases toward the peripheral portion, or a smaller proportion of holes is present at the center and the number of holes gradually increases toward the peripheral portion. The former case provides the CMP polishing pad with lower hardness at the center thereof and allows slurry feed to be concentrated at the center. The latter case results in a contrary effect. The distribution of holes may be controlled diversely according to the pattern shape of a material subjected to CMP or the structure of a CMP system.

## Claims

1. A method for manufacturing a CMP polishing pad (102), comprising:
determining a diameter of holes to be formed on a CMP Polishing pad (102);
determining a particular type of laser capable of generating light of a range of visible rays or near IR rays, such as GaAs lasers, Nd-YAG lasers or HF lasers, to be used according to the diameter of the holes;
determining a particular type of light-absorbing material capable of absorbing the light correspoding to near IR rays and visible rays according to the type of laser;
dispersing the light-absorbing material in or on the surface of the CMP polishing pad (102); and
irradiating the CMP polishing pad (102) having the light-absorbing material dispersed with the laser beams to form the holes.

2. The method for manufacturing a CMP polishing pad (102) according to claim 1, wherein the holes have a diameter that is in proportion to a wavelength of laser beams.

3. The method for manufacturing a CMP polishing pad (102) according to claim 1 or 2, wherein the laser beams have a median wavelength of 300-20,000 nm.

4. The method for manufacturing a CMP polishing pad (102) according to one of the preceding claims, wherein the holes have a diameter of 1-200 µm.

5. The method for manufacturing a CMP polishing pad (102) according to one of the preceding claims, wherein the light-absorbing material absorbs light in a wavelength range of 300-15,000 nm.

6. The method for manufacturing a CMP polishing pad (102) according to one of the preceding claims, wherein the light-absorbing material may be at least one material selected from the group comprising cyanine dyes, dithiolene dyes, diimmonium dyes, quinone dyes, rhodamine dyes, victoria dyes, methylene dyes, brilliant dyes, naphthalene dyes, repid-filter gelb, echtblau, pinaorthol dyes, pyrylium dyes, thionin dyes, nile blue dyes, cresyl dyes, oxazine dyes, resorufin dyes, resazurin dyes, pyronin dyes, acridine dyes and kiton dyes.

7. The method for manufacturing a CMP polishing pad (102) according to one of the preceding claims, wherein a plurality of holes is to be formed on the CMP polishing pad (102), and distribution and depth of the holes are controlled by varying a position of the CMP polishing pad (102).

8. The method for manufacturing a CMP polishing pad (102) according to one of the preceding claims, wherein a plurality of holes is to be formed on the CMP polishing pad (102), and distribution and depth of the holes are controlled by varying a position of the laser.

9. The method for manufacturing a CMP polishing pad (102) according to one of the preceding claims, wherein the step of dispersing the light-absorbing material in or on the surface of the CMP polishing pad (102) is performed by attaching a film having a light-absorbing material dispersed therein to the surface of the CMP polishing pad (102).

10. The method for manufacturing a CMP polishing pad (102) according to one of the preceding claims, wherein a plurality of holes is generated in the CMP polishing pad (102) by forming a light-absorbing material layer on the surface of the CMP polishing pad (102) and irradiating the light-absorbing material layer with laser beams so that the laser beams penetrate through the light-absorbing material layer and the holes are formed to a predetermined depth of the CMP polishing pad (102).

## Patentansprüche

1. Verfahren zum Herstellen eines CMP-Polierkissens (102), umfassend:
Ermitteln eines Durchmessers von Löchern, welche auf dem CMP-Polierkissen (102) gebildet werden sollen;
Ermitteln eines bestimmten Lasertyps, welcher geeignet ist, Licht im Bereich von sichtbarer oder naher Infrarotstrahlung zu erzeugen, wie GaAs-Laser, Nd-YAG-Laser oder HF-Laser, welcher gemäß dem Durchmesser der Löcher verwendet werden soll;
Ermitteln eines bestimmten Typs eines lichtabsorbierenden Materials, geeignet zum Absorbieren des Lichts, welches gemäß dem Lasertyp zur nahen Infrarotstrahlung oder sichtbaren Strahlung korrespondiert;
Dispergieren des lichtabsorbierenden Materials in oder auf der Oberfläche des CMP-Polierkissens (102); und
Bestrahlen des das dispergierte lichtabsorbierende Material aufweisende CMP-Polierkissens (102) mit den Laserstrahlen, um die Löcher zu bilden.

2. Verfahren zum Herstellen eines CMP-Polierkissens (102) nach Anspruch 1, wobei die Löcher einen Durchmesser aufweisen, welcher in einem Verhältnis zu einer Wellenlänge der Laserstrahlen steht.

3. Verfahren zum Herstellen eines CMP-Polierkissens (102) nach Anspruch 1 oder 2, wobei die Laserstrahlen eine mittlere Wellenlänge von 300-20.000 nm aufweisen.

4. Verfahren zum Herstellen eines CMP-Polierkissens (102) nach einem der vorhergehenden Ansprüche, wobei die Löcher einen Durchmesser von 1-200 µm aufweisen.

5. Verfahren zum Herstellen eines CMP-Polierkissens (102) nach einem der vorhergehenden Ansprüche, wobei das lichtabsorbierende Material Licht in einem Wellenlängenbereich von 300-15.000 nm absorbiert.

6. Verfahren zum Herstellen eines CMP-Polierkissens (102) nach einem der vorhergehenden Ansprüche, wobei das lichtabsorbierende Material zumindest ein Material sein kann, welches aus der Gruppe umfassend Zyanin-Farben, Dithiolen-Farben, Diimmonium-Farben, Quinon-Farben, Rhodamin-Farben, Viktoria-Farben, Methylen-Farben, Brilliant-Farben, Naphthalin-Farben, Repid-Filter Gelb, Echtblau, Pinaorthol-Farben, Pyrylium-Farben, Thionin-Farben, Nilblau-Farben, Cresyl-Farben, Oxazin-Farben, Resorufin-Farben, Resazurin-Farben, Pyronin-Farben, Acridin-Farben und Kiton-Farben ausgewählt ist.

7. Verfahren zum Herstellen eines CMP-Polierkissens (102) nach einem der vorhergehenden Ansprüche, wobei eine Vielzahl von Löchern auf dem CMP-Polierkissen (102) gebildet werden, und die Verteilung und Tiefe der Löcher durch Variieren der Position des CMP-Polierkissens (102) gesteuert wird.

8. Verfahren zum Herstellen eines CMP-Polierkissens (102) nach einem der vorhergehenden Ansprüche, wobei eine Vielzahl von Löchern auf dem CMP-Polierkissen (102) gebildet werden, und die Verteilung und Tiefe der Löcher durch Variieren der Position des Lasers gesteuert wird.

9. Verfahren zum Herstellen eines CMP-Polierkissens (102) nach einem der vorhergehenden Ansprüche, wobei der Schritt des Dispergierens von lichtabsorbierenden Material in oder auf der Oberfläche des CMP-Polierkissens (102) ausgeführt wird, indem ein Film, in welchem das lichtabsorbierende Material dispergiert ist, auf der Oberfläche des CMP-Polierkissens (102) angebracht wird.

10. Verfahren zum Herstellen eines CMP-Polierkissens (102) nach einem der vorhergehenden Ansprüche, wobei eine Vielzahl von Löchern in dem CMP-Polierkissen (102) erzeugt wird, indem eine lichtabsorbierende Materialschicht auf der Oberfläche des CMP-Polierkissens (102) gebildet wird und die lichtabsorbierende Materialschicht mit Laserstrahlen bestrahlt wird, so dass die Laserstrahlen durch die lichtabsorbierende Materialschicht durchdringen und die Löcher mit einer vorbestimmten Tiefe des CMP-Polierkissens (102) gebildet werden.

## Revendications

1. Procédé de fabrication d'un tampon de polissage CMP (102) comprenant:
la détermination d'un diamètre de trous à former sur un tampon de polissage CMP (102);
la détermination d'un type particulier de laser capable de générer de la lumière d'une plage de rayons visibles ou de rayons IR proches, tels que lasers AsGa, lasers Nd-YAG ou lasers HF, à utiliser selon le diamètre des trous;
la détermination d'un type particulier de matériau absorbant la lumière capable d'absorber la lumière correspondant à des rayons IR proches et des rayons visibles selon le type de laser;
la dispersion du matériau absorbant la lumière dans ou sur la surface du tampon de polissage CMP (102); et
l'irradiation du tampon de polissage CMP (102) comportant le matériau absorbant la lumière dispersé avec les faisceaux laser pour former les trous.

2. Procédé de fabrication d'un tampon de polissage CMP (102) selon la revendication 1, en ce que les trous présentent un diamètre qui est proportionnel à une longueur d'onde des faisceaux laser.

3. Procédé de fabrication d'un tampon de polissage CMP (102) selon la revendication 1 ou 2, en ce que les faisceaux laser présentent une longueur d'onde moyenne de 300 à 20 000 nm.

4. Procédé de fabrication d'un tampon de polissage CMP (102) selon l'une des revendications précédentes, en ce que les trous présentent un diamètre de 1 à 200 µm.

5. Procédé de fabrication d'un tampon de polissage CMP (102) selon l'une des revendications précédentes, en ce que le matériau absorbant la lumière absorbe la lumière dans une plage de longueur d'onde comprise entre 300 et 15 000 nm.

6. Procédé de fabrication d'un tampon de polissage CMP (102) selon l'une des revendications précédentes, en ce que le matériau absorbant la lumière peut être au moins un matériau sélectionné à partir du groupe comprenant des colorants cyanine, des colorants dithiolène, des colorants diimmonium, des colorants quinoniques, des colorants rhodamine, des colorants victoria, des colorants méthylène, des colorants brillants, des colorants naphtalène, filtre repid jaune, vrai bleu, des colorants pinaorthol, des colorants pyrylium, des colorants de thionine, des colorants bleu de Nil, des colorants de crésyle, des colorants d'oxazine, des colorants résorufine, des colorants résazurine, des colorants pyronine, des colorants acridine et des colorants Kiton.

7. Procédé de fabrication d'un tampon de polissage CMP (102) selon l'une des revendications précédentes, en ce qu'une pluralité de trous doit être formée sur le tampon de polissage CMP (102), et la répartition ainsi que la profondeur des trous sont contrôlées en faisant varier une position du tampon de polissage CMP (102).

8. Procédé de fabrication d'un tampon de polissage CMP (102) selon l'une des revendications précédentes, en ce qu'une pluralité de trous doit être formée sur le tampon de polissage CMP (102), et la répartition ainsi que la profondeur des trous sont contrôlées en faisant varier une position du laser.

9. Procédé de fabrication d'un tampon de polissage CMP (102) selon l'une des revendications précédentes, en ce que l'étape de dispersion du matériau absorbant la lumière dans ou sur la surface du tampon de polissage CMP (102) est effectuée par fixation d'un film présentant un matériau absorbant la lumière qui y est dispersé à la surface du tampon de polissage CMP (102).

10. Procédé de fabrication d'un tampon de polissage CMP (102) selon l'une des revendications précédentes, en ce qu'une pluralité de trous est générée dans le tampon de polissage CMP (102) en formant une couche de matériau absorbant la lumière sur la surface du tampon de polissage CMP (102) et irradiant la couche de matériau absorbant la lumière avec des faisceaux laser de manière à ce que les faisceaux laser pénètrent à travers la couche de matériau absorbant la lumière et à ce que les trous soient formés à une profondeur prédéterminée du tampon de polissage CMP (102).
